# EUROPÄISCHE PATENTSCHRIFT

(11) **EP 0 811 667 B1**
(45) Veröffentlichungstag und Bekanntmachung des Hinweises auf die Patenterteilung: **30.06.2004**
(21) Anmeldenummer: 97109032.9
(22) Anmeldetag: 04.06.1997
(51) Int. Cl.: C09J 5/00

(54) **Verfahren zur Herstellung mechanisch fester Klebstoffverbindungen zwischen Oberflächen**
Method of manufacturing adhesive joints between surfaces, having good mechanical strength
Méthode de réalisation de liaisons de surfaces par adhésifs, d'une bonne résistance mécanique

(30) Priorität: 05.06.1996 DE 19622684
(43) Veröffentlichungstag der Anmeldung: 10.12.1997
(73) Patentinhaber: Infineon Technologies AG, 81669 München (DE)
(72) Erfinder: Honsberg-Riedl, Martin, Dr., 83435 Bad Reichenhall (DE); Seeberger, Daniel, 80799 München (DE); Höhn, Klaus, Dr., 82024 Taufkirchen (DE); Plickert, Volker, 14656 Brieselang (DE)
(74) Vertreter: Schweiger, Martin, Dipl.-Ing.

(56) Entgegenhaltungen:
- EP-A- 0 237 114
- US-A- 5 107 371
- CHUJI KAGAYA: "THE INFLUENCE OF THE SURFACE ROUGHNESS AND THE THICKNESS OF ADHESIVE LAYER ON THE ADHESIVE STRENGHT BETWEEN METALLIC SURFACES" MEMOIRS CHUBU INSTITUTE OF TECNOLOGY, Bd. 6, 1. September 1970, Seiten 13-17, XP002045173 JAPAN
- PATENT ABSTRACTS OF JAPAN vol. 96, no. 8, 30. August 1996 & JP 08 087727 A (SONY CORPORATION), 2. April 1996

## Beschreibung

Die Erfindung betrifft einen Klebeverbund, sowie ein Verfahren zur Herstellung einer mechanisch festen Klebstoffverbindung zwischen Oberflächen.

Aus der Druckschrift US 5,107,371 ist eine Verbundlinse bekannt, deren Komponenten über eine Klebstoffschicht mit angepaßtem Brechungsindex verbunden sind.

Ein Verfahren zur Herstellung einer mechanisch festen Klebstoffverbindung ist aus Elektronik Produktion und Prüftechnik, Mai 1989, S. 40 - 44 bekannt.

Bei diesem bekannten Verfahren weisen die sich über eine Fläche erstreckenden und zur Herstellung der Klebstoffverbindung vorgesehenen Oberflächenbereiche der zu verbindenden Oberflächen eine geringe Rauhtiefe von 0,5 bis etwa 2 µm auf. Die verbindende und aus einem ausgehärteten Klebstoff bestehende Klebstoffschicht im Zwischenraum zwischen den Oberflächenbereichen weist eine Dicke von 0,5 bis 1 µm auf.

Bei einer Ausführung dieses bekannten Verfahrens werden die zur Herstellung der Klebstoffverbindung vorgesehenen Oberflächenbereiche zuerst zusammengesetzt und der aus Cyanacrylat bestehende niedrigviskose Klebstoff anschließend durch die Oberflächenspannung in den Zwischenraum eingebracht .

Bei einer anderen Ausführung dieses Verfahrens wird ein aus Epoxid bestehender Klebstofftropfen mit Hilfe eines Extruders zunächst auf eine der zu verbindenden Oberflächen aufgebracht und anschließend die andere Oberfläche mit einem Druck von 30 cN/mm² aufgesetzt.

Mit diesem bekannten Verfahren lassen sich leitfähige Klebstoff Verbindungen mit nicht gefüllten, d. h elektrisch isolierenden Klebstoffen herstellen.

Aus der EP-0 237 114 B1 ist ein Verfahren zur Herstellung einer elektrisch leitenden Klebstoffverbindung zwischen elektrisch leitenden Teilen bekannt, deren zu verklebende Oberflächen ebenfalls eine Rauhtiefe aufweisen.

Bei diesem bekannten Verfahren werden die zu verbindenden Oberflächen jeweils mit einer Schicht aus mindestens einem Übergangselement der ersten und/oder der zweiten Übergangsreihe des periodischen Systems der Elemente versehen, der eine Rauhtiefe im µm-Bereich erteilt wird.

Zur Herstellung der Klebstoffverbindung wird ein elektrisch nichtleitender Klebstoff in einer solchen Menge eingesetzt, daß die erhabenen Bereiche der Übergangselement-Schichten noch Kontakt miteinander erreichen.

Die bei diesem Verfahren verwendeten Rauhtiefen betragen einige 0,1 µm bei Verwendung von Kupfer als Übergangselement und sind größer, beispielsweise etwa 1 µm, bei anderen verwendeten Übergangselementen.

Die gewünschte Rauhtiefe kann durch einen Ionenätzprozess erreicht werden.

Der Klebstoff wird durch dünnes Bestreichen auf einer der zu verbindenden Oberflächen aufgebracht und kann u.a. aus Kleblack auf Cyanacrylat-, Epoxidharz- oder Polyester-Basis bestehen.

Der Übergangswiderstand von nach diesem Verfahren hergestellten Klebstoffverbindungen liegt bei gleichzeitiger mechanischer und thermischer Belastung im Bereich von 3 bis 9 mΩ/mm² Kontaktfläche.

Die japanische Firma Matsushita verwendet zur Herstellung einer elektrisch leitenden Klebstoffverbindung zwischen einem elektronischen bzw. mikroelektronischen Baustein und einem Substratkörper ein Klebstoffverfahren mit einem elektrisch isolierenden Klebstoff, bei welchem die mit der Oberfläche des Substratkörpers zu verbindende Oberfläche des Bausteins, beispielsweise mit einem 10µm-Raster angeordnete Höcker aus Gold mit einer Höhe von mindestens 3 µm und einer Fläche von 25 µm aufweist.

Zur Herstellung der Klebstoffverbindung wird die mit den Anschlüssen versehene Oberfläche des Substratkörpers mit einem elektrisch isolierenden, im UV-Licht härtenden Klebstoff beschichtet, der beim Härten schrumpft.

Die mit den Höckern versehene Oberfläche des Bausteins und die mit den Anschlüssen versehene Oberfläche des Substratkörpers werden derart einander gegenübergesetzt, daß jedem Hökker des Bausteins je ein Anschluß des Substratkörpers gegenüberliegt.

Danach werden die beiden Oberflächen mit einem Druck von beispielsweise 1,5 bis 3 cN/25 µm² gegeneinander gedrückt und mit UV-Licht belichtet, beispielsweise 3 Sekunden lang bei 1 mW/cm².

Durch die beim Härten des Klebstoffs entstehende Schrumpfspannung werden die einander gegenüberliegenden Höcker und Anschlüsse bleibend gegeneinandergedrückt, so daß keine elektrisch wirksame Barrierelage entsteht (Übergangswiderstand 18 mΩ). Es besteht eine hohe Zuverlässigkeit auch nach Schock (-55/125°C, 1000 Z), Temperaturlagerung (125°C,1000 h), feuchter Wärme (85°C/85%, 100h).

Als Substratkörper können Glas-, Keramik- und Hartsubstratkörper verwendet werden.

Mit diesem Verfahren konnten LED-Arrays mit IC-Ansteuerung realisiert werden, die in einem Raster von 63,5 µm und 100 µm angeordnete Höcker von 7 µm Höhe aufwiesen.

Der Erfindung liegt die Aufgabe zugrunde, aufzuzeigen, haltbare mechanisch feste Klebstoffverbindungen zwischen Oberflächen bei minimalem Aufwand an Klebstoff zu erreichen.

Diese Aufgabe wird mit dem Gegenstand der unabhängigen Ansprüche gelöst. Vorteilhafte Weiterbildungen der Erfindung ergeben sich aus den abhängigen Ansprüchen.

Der Erfindung liegt die neue und überraschende Erkenntnis zugrunde, daß trotz geringer Rauhtiefen von weniger als 0,3 /µm und eines zum Kleben zur Verfügung stehenden, flächig sich erstreckenden Zwischenraums einer geringen mittleren Dicke von weniger als 0,3 /µm mechanisch feste Klebstoffverbindungen zwischen Oberflächen entstehen, die ausreichend haltbar sind.

Eine besonders bevorzugte und vorteilhafte Ausgestaltung des erfindungsgemäßen Verfahrens ist gekennzeichnet durch ein sich Ausbreitenlassen eines dünnflüssigen Klebstoffs einer derart niedrigen dynamischen Viskosität, daß sich der Klebstoff infolge von Kapillarwirkung flächig im Zwischenraum der geringen mittleren Dicke von weniger als 0,3 µm ausbreitet (Anspruch 2).

Dabei hat sich gezeigt, daß der geringen Rauhtiefe und der geringen mittleren Dicke des Zwischenraums nach unten insoweit keine Grenzen gesetzt sind, als noch ein Zwischenraum zwischen den zur Herstellung der Klebstoffverbindung vorgesehenen Oberflächen verbleibt, der ausreichend dünnflüssigen Klebstoff infolge von Kapillarwirkung aufnehmen und ein flächiges sich Ausbreitenlassen dieses Klebstoffs in diesem Zwischenraum zuläßt. Derart zulässige Rauhtiefen und mittleren Dicken liegen weit unter 0,2 µm, ja sogar weit unter 0,1 µm.

Unter Rauhtiefe ist der Abstand des Grund- vom Bezugsprofil der zur Herstellung der Klebstoffverbindung vorgesehenen rauhen Oberflächenbereiche zu verstehen (siehe Köhler et al., "Maschinenteile 1", Teubnerverlag, 1986, Seite 75) und unter mittlerer Dicke des Zwischenraums ist hier speziell der Abstand zwischen den mittleren Profilen (siehe ebenfalls "Maschinenteile 1", Seite 75) dieser beiden einander gegenübergesetzten Oberflächenbereiche zu verstehen.

Je kleiner die Rauhtiefe und die mittlere Dicke des Zwischenraums gewählt wird, desto dünnflüssiger muß der zum Kleben verwendete Klebstoff sein.

Die erfindungsgemäß vorgegebene Obergrenze der Rauhtiefe und der mittleren Dicke von 0,3 µm bedingt eine obere Grenze der dynamischen Viskosität des zu verwendenden Klebstoffs, die bei der Temperatur, bei welcher sich der Klebstoff zur Herstellung der Klebstoffverbindung flächig im Zwischenraum zwischen den Oberflächenbereichen ausbreitet, 10³ mPa·s beträgt (Anspruch 3).

Da Klebstoffe in der Regel bei höherer Temperatur eine geringere dynamische Viskosität als bei niedriger Temperatur aufweisen, können Klebstoffe, die beispielsweise bei Raumtemperatur eine für die erfindungsgemäße Herstellung der Klebstoffverbindung zu hohe dynamische Viskosität aufweisen und nicht verwendbar wären, bei höheren Temperaturen durchaus zur erfindungsgemäßen Herstellung dieser Klebstoffverbindung benutzt werden.

Vorteilhaft ist dabei, daß in der Regel nicht nur die dynamische Viskosität des Klebstoffs, sondern auch dessen Oberflächenspannung abnimmt, so daß der Klebstoff leichter in den Zwischenraum der geringen mittleren Dicke eindringen und sich leichter in diesem ausbreiten kann.

Obgleich für die dynamische Viskosität des flüssigen Klebstoffs nach unten hin, d. h. in die Nähe von 1 mPa·s (Viskosität von beispielsweise Wasser oder Azeton) prinzipiell keine Schranke besteht, liegt eine derzeitige praktische untere Grenze bei 10² mPa·s, die jedoch in der Zukunft unterschritten werden dürfte.

Die Erfindung umfaßt zwar den Fall, daß sich die für die Herstellung der Klebstoffverbindung vorgesehenen und einander gegenübergesetzten Oberflächenbereiche bei der geringen mittleren Dicke des Zwischenraums nicht berühren, sondern in einem Abstand voneinander angeordnet sind, doch ist es im Hinblick auf die derzeit praktisch bedeutsamsten Fälle zweckmäßig, so vorzugehen, daß diese Oberflächenbereiche in unmittelbaren Kontakt miteinander zu bringen, wobei der zwischen diesen in Kontakt miteinander stehenden Oberflächenbereichen aufgrund der bestehenden Rauheit dieser Bereiche flächig ausgedehnte Zwischenraum der geringen mittleren Dicke verbleibt, der eine Kapillarwirkung entfaltet (Anspruch 4).

Zu diesen letztgenannten Fällen gehört auch die erfindungsgemäße Herstellung elektrischer und/oder thermischer Kontaktverbindungen mittels elektrisch isolierenden Klebstoffs, auf die später eingegangen wird.

Zum Einbringen des Klebstoffs in den Zwischenraum der geringen mittleren Dicke infolge von Kapillarwirkung (nach Anspruch 2) gibt es zwei erfindungsgemäße Varianten:

Bei der bevorzugteren einen erfindungsgemäßen Variante werden zuerst ohne Verwendung von Klebstoff durch einander Gegenübersetzen der zu verbindenden Oberflächen zwischen den zur Herstellung der Klebstoffverbindung vorgesehenen Oberflächenbereichen der oder die Zwischenräume der geringe mittleren Dicke erzeugt. Zwischen diesen Oberflächen befindet sich also zunächst keinerlei Klebstoff, so daß auch sämtliche vorhandenen Zwischenräume der geringen mittleren Dicke klebstofffrei sind.

Danach erst wird der flüssige Klebstoff in den oder die Zwischenräume eingebracht. Dazu wird der Klebstoff an eine mit einem solchen Zwischenraum verbundene Öffnung herangebracht, von welcher dieser aufgrund von Kapillarwirkung in den Zwischenraum eindringt und sich flächig im Zwischenraum ausbreitet (Anspruch 5).

Die Öffnung kann beispielsweise eine schmale Öffnung des Zwischenraums selbst sein, die sich längs eines äußeren Randes dieses Zwischenraums erstreckt und so schmal wie die mittlere Dicke des Zwischenraums ist. Zweckmäßiger ist es jedoch, wenn diese Öffnung eine relativ größere Öffnung ist, die mit dem Zwischenraum verbunden ist und durch die der herangebrachte Klebstoff in einer etwas größeren Vorratsmenge einbringbar ist, als sie im Zwischenraum verbraucht wird.

Bei der weniger bevorzugten anderen Verfahrensvariante wird der Klebstoff in so geringer Menge auf zumindest eine der zu verbindenden Oberflächen aufgebracht, so daß er diese Oberfläche und/oder einen zur Herstellung der Klebstoffverbindung vorgesehenen Oberflächenbereich dieser Oberfläche nur teilweise bedeckt.

Danach werden die zu verbindenden Oberflächen so einander gegenübergesetzt, daß sich zur Herstellung der Klebstoffverbindung vorgesehene Oberflächenbereiche, die einander zugeordnet sind, gegenüberstehen und danach diese Oberflächen gegeneinandergedrückt werden.

Dabei wird ein anfänglich größerer Abstand zwischen diesen Oberflächenbereichen, der durch den zwischen diesen Oberflächen befindlichen Klebstoff bedingt ist, während des Gegeneinanderdrückens aufgrund des sich infolge von Kapillarwirkung flächig zwischen diesen Oberflächenbereichen verteilenden Klebstoffs so weit verringert, daß zwischen den Oberflächenbereichen der mit Klebstoff flächig ausgefüllte Zwischenraum der geringen mittleren Dicke entsteht. Danach wird der Klebstoff ausgehärtet (Anspruch 6).

Bei diesem Fall wird die Kapillarwirkung durch einen zusätzlich auf den Klebstoff ausgeübten Druck unterstützt.

Es sei darauf hingewiesen, daß unter die Erfindung auch Verfahren fallen, bei denen beispielsweise zunächst eine oder beide zu verbindenden Oberflächen ganzflächig oder zumindest in einem Oberflächenbereich vollständig mit flüssigem Klebstoff beschichtet, die derart beschichteten Oberflächen einander gegenübergesetzt und danach der Klebstoff durch Gegeneinanderdrücken der Oberflächen zumindest weitgehend ohneAusnutzung von Kapillarwirkung solange aus den Oberflächen oder Oberflächenbereichen verdrängt wird, bis zwischen einander gegenüberliegenden Oberflächenbereichen der geringen Rauhtiefe von weniger als 0,3 µm der den Klebstoff enthaltende Zwischenraum der geringen mittleren Dicke von weniger als 0,3 µm entsteht. Bei diesem Verfahren muß jedoch eine vergleichsweise größere Menge Klebstoff verwendet werden.

Vielfach ist es so, daß die zu verbindenden Oberflächen Formunterschiede aufweisen, durch die eine sich über einen größeren Flächenbereich erstreckende Klebstoffverbindung nicht möglich ist, weil der Zwischenraum der geringen mittleren Dicke zwischen den einander gegenübergesetzten und für die Herstellung der Klebstoffverbindung vorgesehenen Oberflächenbereichen über diesem größeren Flächenbereich nicht möglich ist.

Sind jedoch die zu verbindenden Oberflächen elastisch verformbar, können durch Gegeneinanderdrücken der zu verbindenden Oberflächen solche Formunterschiede ausgeglichen und zwischen diesen Oberflächen ein Zwischenraum der geringen mittleren Dicke zwischen den einander gegenübergesetzten und für die Herstellung der Klebstoffverbindung vorgesehenen Oberflächenbereichen hergestellt werden, der zumindest während des sich Ausbreitens und Aushärtenlassens des Klebstoffs im Zwischenraum zwischen diesen Oberflächen aufrechterhalten werden kann (Anspruch 7).

Dabei reicht es vorteilhafterweise aus, wenn die zu verbindenden Oberflächen mit einem Druck von weniger als 1000 cN/mm² gegeneinander gedrückt werden (Anspruch 8). Dieser Druckwert ist eine Obergrenze. In der Praxis hat es sich gezeigt, daß vorteilhafterweise ein Druck von weniger als 50 cN/mm2 zum Gegeneinanderdrücken der zu verbindenden Oberflächen genügt (Anspruch 9).

Solche Druckwerte reichen auch bei dem weiter oben genannten Verfahren aus, bei welchem der Klebstoff vor dem einander gegenübersetzen der für die Herstellung der Klebstoffverbindung vorgesehenen Oberflächenbereiche auf zumindest eine der zu verbindenden Oberflächen aufgebracht wird.

Wie oben bereits darauf hingewiesen worden ist, kann es in mehrfacher Hinsicht vorteilhaft sein, ein sich Ausbreitenlassen des Klebstoffs im Zwischenraum der geringen mittleren Dicke bei einer höheren Temperatur vorzunehmen, worunter insbesondere Temperaturen fallen, die großer als die Raumtemperatur, d.h. 20°C, sind (Anspruch 10).

Bei thermisch aushärtbaren Klebstoffen ist in Bezug auf die Aushärtungstemperatur, bei welcher der Klebstoff aushärtet, darauf zu achten, daß die die zum sich Ausbreitenlassen des Klebstoffs im Zwischenraum der geringen mittleren Dicke infolge von druckunterstützter oder nicht druckunterstützter Kapillarwirkung erforderliche niedrige dynamische Viskosität gewährleistet bleibt.

Oben wurde bereits angedeutet, daß es zweckmäßig ist, den dünnflüssigen Klebstoff in etwas größerer Vorratsmenge an den Zwischenraum der geringen mittleren Dicke heranzubringen. Dazu ist es vorteilhaft, wenn der dünnflüssige Klebstoff durch zumindest einen mit einem Zwischenraum der geringen mittleren Dicke in Klebstoffverbindung stehenden Kanal zum Zwischenraum gebracht wird, wobei der Kanal so ausgebildet ist, daß sich in diesem Kanal der Klebstoff aufgrund von Kapillarwirkung schneller im Vergleich zu einer kapillarwirkungsbedingten Ausbreitungsgeschwindigkeit des Klebstoffs im Zwischenraum ausbreitet (Anspruch 11).

Dazu kann ein Kanal verwendet werden, der mit einer Öffnung in eine der zu verbindenden Oberfläche mündet (Anspruch 12) und/oder ein sich in einer Längsrichtung parallel zu einer zu verbindenden Oberfläche erstreckender Kanal mit zumindest einer Längsseite, die mit dem Zwischenraum verbunden ist und von der sich der Klebstoff in Richtung quer zur Längsrichtung des Kanals infolge von Kapillarwirkung in den Zwischenraum ausbreitet (Anspruch 13).

Vorteilhafterweise wird ein optisch transparenter Klebstoff verwendet (Anspruch 14), der insbesondere bei der Herstellung von Klebstoffverbindungen an optischen und/oder optoelektronischen Bauelementen günstig ist.

Obgleich die Verwendung elektrisch leitender Klebstoffe nicht ausgeschlossen sind, wird bei der vorliegenden Erfindung vorzugsweise ein elektrisch isolierender Klebstoff verwendet (Anspruch 15), insbesondere ein Klebstoff auf Epoxiodharzbasis (Anspruch 16).

Die vorliegende Erfindung ist besonders vorteilhaft zur Herstellung elektrischer und/oder thermischer Kontakte geeignet. In diesem Fall bestehen einander gegenüberzusetzende und für die Herstellung der Klebstoffverbindung vorgesehenen Oberflächenbereiche aus elektrischen (Anspruch 17) und/oder thermischen Kontaktflächen (Anspruch 18).

Dabei gereicht die bei der vorliegenden Erfindung verwendete und vergleichsweise besonders geringe Rauhtiefe der Kontaktflächen zum besonderen Vorteil, insbesondere dann, wenn die Kontaktflächen zuerst in Kontakt miteinander gebracht und erst danach der Klebstoff infolge von Kapillarwirkung in den verbliebenen Zwischenraum zwischen den in unmittelbarem Kontakt miteinander stehenden Kontaktflächen eingebracht wird.

Die besonders geringe Rauhtiefe gewährleistet, daß ein viel größerer Prozentsatz der in unmittelbaren Kontakt miteinander zu bringenden Kontaktflächen in direktem Kontakt miteinander stehen, als es bei größeren Rauhtiefen der Fall ist. Dadurch sind von vornherein sehr niedrige elektrische und/oder thermische Übergangswiderstände gewährleistet, die im elektrischen Fall unter 1 mΩ·mm² Kontaktfläche liegen und vorraussichtlich in der Zukunft noch weiter erniedrigt werden können.

Da aufgrund des genannten größeren Prozentsatzes ein vergleichsweise kleinerer Prozentsatz an Fläche für den Klebstoff zur Verfügung steht, ist bei dem erfindungsgemäßen Verfahren eine mechanisch wenig feste und schlecht haltbare Klebstoffverbindung zu erwarten. Es hat sich jedoch überraschenderweise das Gegenteil herausgestellt. Trotz der vermeintlich ungünstigen Umstände wird durch das erfindungsgemäße Verfahren eine ausreichend haltbare mechanisch feste Klebstoffverbindung erzielt.

Insbesondere aus Gold bestehende Kontaktflächen (Anspruch 19) haben sich bei dem erfindungsgemäßen Verfahren für die Herstellung mechanisch fester und haltbarer Klebeverbindungen als günstig erwiesen. Mit einer aus Gold bestehenden Kontaktfläche und einem dünnflüssigen Klebstoff auf Epoxidharzbasis konnte mit dem erfindungsgemäßen Verfahren eine sehr dauerhafte mechanisch feste und temperaturbeständige Klebstoffverbindung erhalten werden. Es können insbesondere elektrische und/oder thermische Kontakte einer Güte erhalten werden, die beispielsweise bei Temperaturwechseltests zwischen -40°C und +85°C und 500 Zyklen mit einem Zyklus pro Stunde gleich bleibt.

Weitere bevorzugte und vorteilhafte Ausgestaltungen des erfindungsgemäßen Verfahrens gehen aus den Ansprüchen 20 bis 25 hervor.

Durch das erfindungsgemäße Verfahren ist auch eine neuartige mechanisch feste Klebstoffverbindung zwischen Oberflächen geschaffen, die im Anspruch 26 angegeben ist und die sich durch eine besonders dünne Klebstoffschicht auszeichnet. Eine bevorzugte Ausgestaltung dieser Klebstoffverbindung geht aus dem Anspruch 27 hervor.

Als besondere Vorteile der Erfindung sind zu nennen, daß durch die Verwendung kleinster Klebstoffmengen die mittlere Schichtdicke der verbindungswirksamen Klebstoffschicht extrem dünn gehalten und die Dosierung und Verteilung des flüssigen Klebstoffs durch verwendung von Kanälen erleichtert werden kann.

Eine zu verbindende Oberfläche kann nur einen oder mehrere voneinander getrennte jeweils zur Herstellung der erfindungsgemäßen Klebstoffverbindung vorgesehene Oberflächenbereiche der geringen Rauhtiefe von weniger als 0,3 µm aufweisen. Ein einzelner solcher Oberflächenbereich kann sich über die ganze zu verbindende Oberfläche erstrecken, insbesondere so, daß er mit dieser Oberfläche identisch ist. Bei bevorzugten Ausgestaltungen sind die Oberflächenbereiche matrixförmig in Zeilen und Spalten auf der betreffenden Oberfläche verteilt.

Die Erfindung wird anhand der Figuren in der nachfolgenden Beschreibung beispielhaft näher erläutert. Es zeigen:
- Figur 1: in Seitenansicht ein Ausführungsbeispiel der Erfindung mit zwei durch eine erfindungsgemäße Kleb stoffverbindung verbundenen Körpern,
- Figur 2: den in Figur 1 mit dem Kreis A umrissenen Ausschnitt der erfindungsgemäßen Klebstoffverbindung in stark vergrößerter Darstellung, wobei angenommen ist, daß die zur Herstellung der Klebstoffverbindung vorgesehenen Oberflächenbereiche in unmittelbarem Kontakt miteinander stehen und der dazwischen befindliche Klebstoff noch flüssig und nicht ausge härtet ist,
- Figur 3: den vergrößerten Ausschnitt nach Figur 2, wobei an genommen ist, daß die Oberflächenbereiche nicht in Kontakt miteinander stehen, sondern in einem größe ren Abstand voneinander angeordnet sind, und der dazwischen befindliche Klebstoff flüssig und nicht ausgehärtet ist,
- Figur 4: den vergrößerten Ausschnitt nach Figur 2 in der gleichen Annahme des unmittelbaren Kontaktes der Oberflächenbereiche miteinander, jedoch mit dem Un terschied, daß der dazwischen befindliche Klebstoff ausgehärtet ist und eine harte Klebstoffschicht bildet, und
- Figuren 5 bis 8: drei Modifikationen der Ausführungsform nach Figur 1, wobei die Figur 5 eine erste Modifikation in Seitenansicht, Figur 6 die erste Modifikation in Draufsicht, Figur 7 einen Querschnitt durch eine zweite Modifikation und Figur 8 in Seitenansicht die dritte Modifikation darstellt.

In den Figuren sind gleiche oder einander entsprechende Teile mit den gleichen Bezugszeichen versehen. Die Figuren sind schematisch und nicht maßstäblich.

Bei den in den Figuren dargestellten Beispielen sind mit 1 und 2 zwei Körper mit einander zugekehrten Oberflächenabschnitten 100 bzw. 200 bezeichnet. Der Oberflächenabschnitt 100 des Körpers 1 bildet eine flache Seitenfläche dieses Körpers 1, der Oberflächenabschnitt 200 des Körpers 2 eine flache Seitenfläche dieses anderen Körpers 2.

Auf dem Oberflächenabschnitt 100 des Körpers 1 sind mehrere, beispielsweise zwei voneinander getrennte Schichten 11 aus einem bestimmten Material und einer bestimmten Schichtdicke d1 angeordnet, deren freiliegende Oberfläche zusammen mit dem freigebliebenen Teil des Oberflächenabschnitts 100 eine mit einer anderen Oberfläche zu verbindende Oberfläche 10 dieses Körpers 1 bildet.

In gleicher Weise sind auf dem Oberflächenabschnitt 200 des anderen Körpers 2 mehrere, beispielsweise ebenfalls zwei voneinander getrennte Schichten 21 aus einem bestimmten Material und einer bestimmten Schichtdicke d2 angeordnet, deren freiliegende Oberfläche zusammen mit dem freigebliebenen Teil des Oberflächenabschnitts 200 eine mit der Oberfläche 10 des einen Körpers 1 zu verbindende Oberfläche 20 dieses anderen Körpers 2 bildet.

Die vom Oberflächenabschnitt 100 des Körpers 1 abgekehrte und von diesem Bereich 100 um die Schichtdicke d1 abgesetze Fläche 10₁ jeder Schicht 11 ist mindestens 20×20 µm groß, weist eine erfindungsgemäße Rauhtiefe von weniger als 0,3 µm auf und bildet einen zur Herstellung der erfindungsgemäßen Klebstoffverbindung vorgesehenen Oberflächenbereich der zu verbindenden Oberfläche 10.

Ebenso ist die vom Oberflächenabschnitt 200 des Körpers 2 abgekehrte und von diesem Bereich 200 um die Schichtdicke d2 abgesetze Fläche 20₁ jeder Schicht 21 mindestens 20×20 µm groß, weist eine erfindungsgemäße Rauhtiefe von weniger als 0,3 µm auf und bildet einen zur Herstellung der erfindungsgemäßen Klebstoffverbindung vorgesehenen Oberflächenbereich der zu verbindenden Oberfläche 20.

Zur Herstellung der erfindungsgemäßen Klebstoffverbindung werden die miteinander zu verbindenden Oberflächen 10 und 20. einander zugekehrt derart gegenübergesetzt, daß jedem Oberflächenbereich 10₁ der Oberfläche 10 des Körpers 1 zumindest ein Oberflächenbereich 20₁ der Oberfläche 20 des Körpers 2 und jedem Oberflächenbereich 20₁ der Oberfläche 20 des Körpers 2 zumindest ein Oberflächenbereich 10₁ der Oberfläche 10 des Körpers 1 derart gegenüberliegt, sodaß zwischen jedem Paar einander gegenüberliegender Oberflächenbereiche 10₁, 20₁ je ein flachig ausgedehnter Zwischenraum 30 besteht, der erfindungsgemäß eine geringe mittlere Dicke d von weniger als 0,3 µm aufweist und sich über eine Fläche von wenigstens 20×20 µm² Größe erstreckt.

In diesem Zwischenraum 30 läßt man sich einen dünnflüssigen aushärtbaren Klebstoff 3 flächig infolge von Kapillarwirkung ausbreiten der bei der Temperatur T, bei der das sich Ausbreitenlassen stattfindet, eine niedrige Viskosität zwischen 10³ und 10² mPa·s aufweist.

In der Regel nimmt die Viskosität eines Klebstoffs mit zunehmender Temperatur ab. Deshalb kann ein Klebstoff, der bei einer bestimmten Temperatur, beispielsweise bei Raumtemperatur eine zu hohe Viskosität aufweist, bei einer höheren Temperatur T eine so ausreichend niedrige Viskosität aufweisen, daß er sich bei dieser höheren Temperatur im Zwischenraum 30 ausbreiten kann. In einem solchen Fall wird das sich Ausbreitenlassen des Klebstoffs im Zwischenraum 30 bei dieser höheren Temperatur vorgenommen. Da mit zunehmender Temperatur in der Regel die Oberflächenspannung des Klebstoffs zumindest innerhalb bestimmter Grenzen abnimmt, kann die Verwendung einer höhere Temperatur von Vorteil sein.

Nachdem der Zwischenraum 30 ausreichend, beispielsweise vollständig mit dem dünnfüssigen Klebstoff 3 gefüllt ist, wird der Klebstoff 3 ausgehärtet, wonach die erfindungsgemäße Klebstoffverbindung hergestellt ist.

Das Aushärten kann je nach Art des verwendeten Klebstoffs verschieden sein. Bei thermisch aushärtbaren Klebstoffen 3 beispielsweise erfolgt das Aushärten bei einer bestimmten Aushärtungstemperatur.

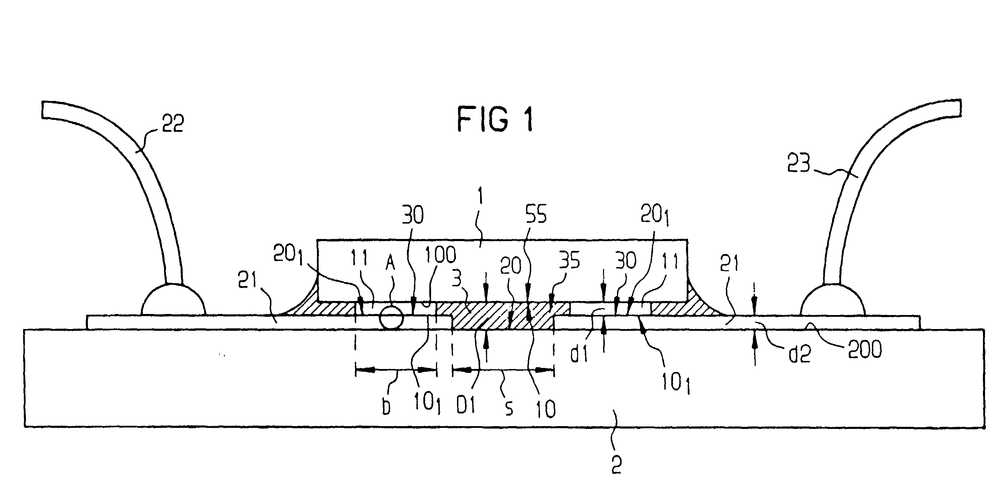

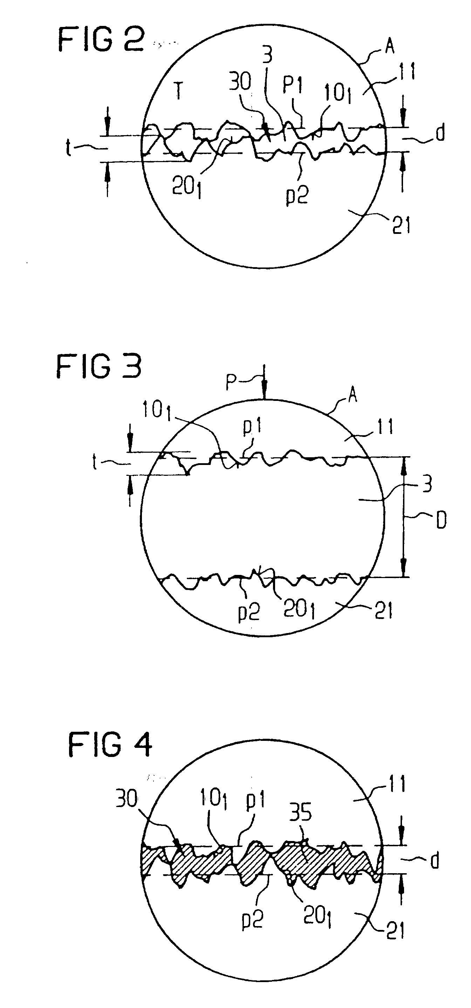

In der Figur 2 ist ein Ausschnitt des Zwischenraums 30 stark vergrößert dargestellt, wobei dieser Ausschnitt der mit dem Kreis A umrissene Teil der Figur 1 ist. Der Zwischenraum 30 befindet sich zwischen den beiden einander gegenüberliegenden Oberflächenbereichen 10₁ und 20₁ zweier einander zugeordneteter Schichten 11 und 21. Jeder dieser Oberflächenbereiche 10₁ und 20₁ weist eine geringe Rauhtiefe t von weniger als 0,3 µm auf. In der Praxis liegt die Rauhtiefe t vielfach weit unter 0,3 µm. Typische Werte der Rauhtiefe t liegen erfindungsgemäß zwischen 5 und 30 nm.

Das mittlere Profil des Oberflächenbereichs 10₁ ist durch die gestrichelte Linie p1 und das mittlere Profil des Oberflächenbereichs 20₁ durch die gestrichelte Linie p2 dargestellt.

Die mittlere Dicke d des Zwischenraums 30 ist durch den Abstand d der beiden mittleren Profile p1 und p2 definiert. Dieser Abstand ist erfindungsgemäß kleiner als 0,3 µm. In der Praxis liegt die mittlere Dicke d vielfach weit unter 0,3 µm. Typische Werte der mittleren Dicke liegen erfindungsgemäß bei 50 nm.

Bei der Figur 2 ist angenommen, daß der Zwischenraum 30 mit noch dünnflüssigem Klebstoff 3 gefüllt ist, der sich bei einer vorgewählten Temperatur T infolge von Kapillarwirkung im Zwischenraum 30 ausgebreitet hat.

Überdies ist bei dem Beispiel nach Figur 2 nicht notwendig angenommen, daß die beiden Oberflächenbereiche 10₁ und 20₁ bei noch fehlendem Klebstoff in unmittelbaren Kontakt miteinander gebracht worden sind und erst danach der dünnflüssige Klebstoff 3 an den Zwischenraum 30 herangebracht wurde, wonach er sich infolge von Kapillarwirkung flächig in diesem Zwischenraum 30 ausgebreitet hat. Demnach hatte in diesem Fall der Zwischenraum 30 von vornherein, d. h. vor dem Einbringen des Klebstoffs 3, die geringe mittlere Dicke d von weniger als 0,3 µm.

Wird dagegen so vorgegangen, daß der Klebstoff 3 vor dem Zusammenbringen der zu verbindenden Oberflächen 10 und 20 auf zumindest eine der beiden Oberflächen in geringer Menge aufgebracht wird, bedingt diese geringe Menge Klebstoffs 3, daß zwischen den einander gegenübergesetzten Oberflächenbereichen 10₁ und 20₁ zunächst ein im Vergleich zur mittleren Dicke d größerer Abstand D vorhanden ist, so, wie es in der Figur 3 gezeigt ist.

Dieser größere Abstand D wird durch Gegeneinanderdrücken der beiden Körper 1 und 2 und damit der beiden Oberflächenbereiche 10₁ und 20₁ mit einem bestimmten Druck P so weit verringert, daß zwischen diesen Oberflächenbereichen 10₁ und 20₁ der mit dem dünnflüssigen Klebstoff 3 gefüllte, flächig ausgedehnte Zwischenraum 30 der geringen mittleren Dicke d entsteht.

Während dieses Gegeneinanderdrückens verteilt sich der dünnflüssige Klebstoff 3 flächig zwischen den Oberflächenbereichen 10₁ und 20₁ infolge druckunterstützter Kapillarwirkung.

Auch bei diesem Verfahren können nach nach Herstellung der geringen mittleren Dicke d des Zwischenraums 30 die einander gegenüberstehenden Oberflächenbereiche 10₁ und 20₁ wie im Fall der Figur 2 im unmittelbaren Kontakt miteinander stehen. Unter die Erfindung fallen aber, gleichgültig welches der beiden vorstehend angegebenen Verfahren angewendet worden ist, auch diejenigen Fälle, bei denen die einander gegenüberstehenden Oberflächenbereiche 10₁ und 20₁ bei der geringen mittleren Dicke d nicht in Kontakt miteinander stehen, beispielsweise so, wie im Fall der Figur 3, bei welcher allerdings D durch d zu ersetzen wäre. Zum Beispiel, aber nicht notwengigerweise, könnte dies der Fall sein, wenn die Rautiefe t bedeutend kleiner als die geringe mittlere Dicke d wäre.

Nach dem Aushärten des flächig im Zwischenraum 30 ausgebreiteten dünnflüssigen Klebstoffs 3 entsteht in jedem Fall eine sich über den ganzen Zwischenraum 30 erstreckende und die Oberflächenbereiche 10₁, und 20₁ miteinander verbindende Schicht 35 aus ausgehärtetem Klebstoff.

Werden bei der Herstellung der Klebstoffverbindung die einander zugeordneten Oberflächenbereiche 10₁, 20₁ klebstofffrei einander gegenübergesetzt, wobei zwischen diesen Oberflächenbereichen 10₁, 20₁ aufgrund der der eine Kapillarwirkung entfaltende, flächig ausgedehnte Zwischenraum 30 der geringen mittleren Dicke d verbleibt, ist es zweckmäßig, den Klebstoff 3 an eine mit dem Zwischenraum 30 verbundene Öffnung 55 heranzubringen, von welcher der Klebstoff 3 aufgrund von Kapillarwirkung in den Zwischenraum 30 eindringt und sich flächig im Zwischenraum 30 ausbreitet.

Im Fall des Beispiels nach den Figuren 1 ist und 8 ist eine solche Öffnung 55 durch den zwischen den beiden Paaren einander gegenüberliegende Schichten 11, 21 und den im Abstand D1 voneinander angeordneten Oberflächenbereichen 100 und 200 befindlichen Raum definiert, wobei der Abstand D1 in der Regel größer als die geringe mittlere Dicke d des Zwischenraums 30 ist.

Oft ist der Abstand D1 so klein vorgegeben, daß sich in dem durch ihn definierten Raum der dünnflüssige Klebstoff 3 mit einer zu einer gegebenen Ausbreitungsgeschwindigkeit des Klebstoffs 3 im Zwischenraum 30 der geringen mittleren Dicke d aufgrund von Kapillarwirkung vergleichbaren Ausbreitungsgeschwindigkeit und daher ähnlich langsam wie im Zwischenraum 30 ausbreitet, so daß der Klebstoff 3 sehr langsam an den Zwischenraum 30 heranbringbar ist.

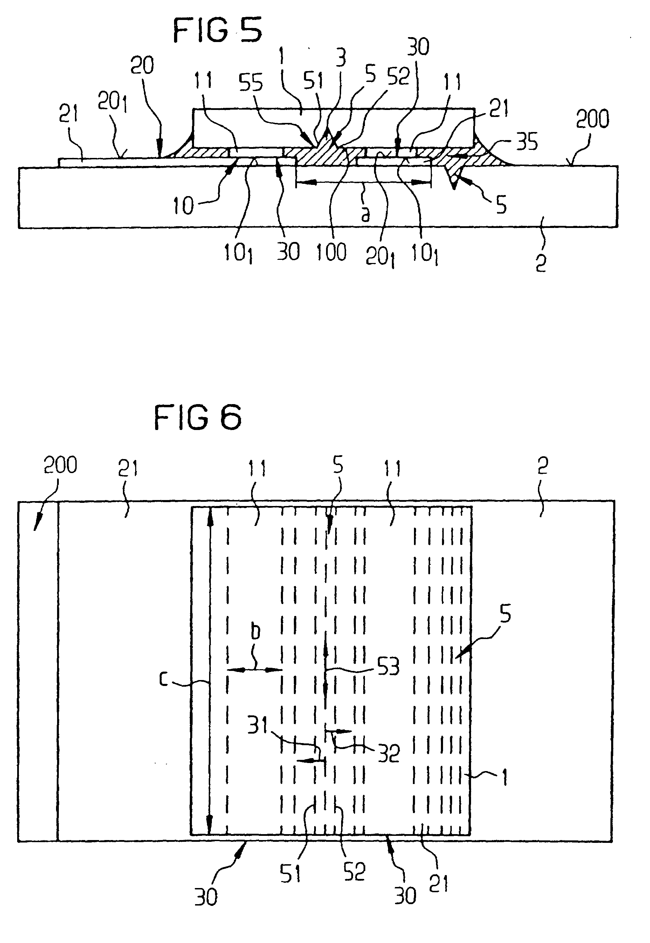

Dem kann dadurch abgeholfen werden, daß der dünnflüssige Klebstoff 3 durch zumindest einen mit dem Zwischenraum 30 der geringen mittleren Dicke d in Klebstoffverbindung stehenden Kanal 5 (siehe Figuren 5 bis 7) zum Zwischenraum 30 gebracht wird, wobei der Kanal 5 so bemessen ist, daß sich in ihm der Klebstoff 3 schneller im Vergleich zur gegebenen Ausbreitungsgeschwindigkeit des Klebstoffs 3 im Zwischenraum 30 aufgrund von Kapillarwirkung ausbreitet.

Günstig ist beispielsweise ein sich in einer Längsrichtung 53 parallel zu einer zu verbindenden Oberfläche 10, 20 erstrekkender Kanal 5 gemäß den Figuren 5 und 6 mit zumindest einer Längsseite 51 und/oder 52, die mit einem zugeordneten Zwischenraum 30 verbunden ist und von der sich der Klebstoff 3 in Richtung 31 bzw.32 quer zur Längsrichtung 53 dieses Kanals 5 infolge von Kapillarwirkung in den Zwischenraum 30 ausbreitet. Ein solcher Kanal 5 kann im Körper 1 und/oder im Körper 2 ausgebildet sein. Beim dargestellten Beispiel ist ein Kanal 5 durch eine V-förmige Nut im Oberflächenabschnitt 100 des Körpers 1 und/oder Oberflächenabschnitt 200 des Körpers 2 realisiert, die z. B. durch anisotropes Ätzen erzeugt werden kann.

Nach Figur 6 erstrecken sich beispielsweise sowohl jeder Kanal 5 als auch jeder zur Herstellung der erfindungsgemäßen Klebstoffverbindung vorgesehene Oberflächenbereich 10₁, 20₁ und damit jeder Zwischenraum 30 über die ganze Breite c des Körpers 1. Die senkrecht zu dieser Breite c gemessene Breite der von zwei einander gegenüberliegenden Schichten 11 und 21 schmaleren Schicht 11 ist mit b bezeichnet. Die Fläche b×c dieser schmaleren Schicht 11 bestimmt bei diesem Beispiel zugleich die Fläche des Zwischenraums 30 der mittleren Dicke d zwischen den einander gegenüberliegenden Oberflächenbereichen 10₁ und 20₁. Erfindungsgemäß muß b×c größer als 20×20 µm gewählt werden und jeder dieser Oberflächenbereiche 10₁, 20₁ muß mindestens diese Fläche aufweisen. Nach oben gibt es für die Größe der Fläche des Zwischenraums 30 prinzipiell keine Grenze.

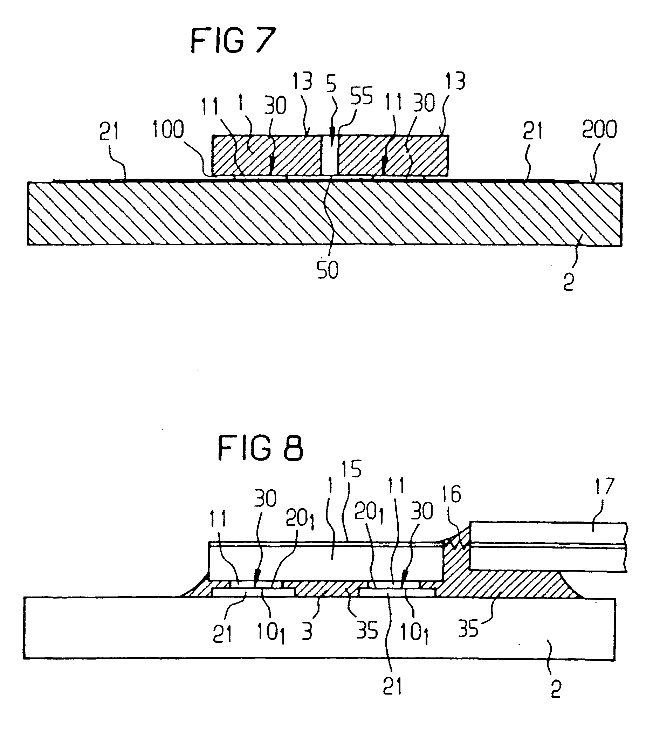

Alternativ zu einem Kanal der Ausführungsform nach den Figuren 5 und 6 oder zusätzlich kann ein Kanal 5 verwendet werden, der mit einer Öffnung 50 in eine zu verbindende Oberfläche 10 oder 20 mündet. Die Figur 7 zeigt ein Beispiel eines solchen Kanals 5, der mit der Öffnung 50 in die Oberfläche des Körpers 1 mündet und diese Öffnung 50 mit einer auf der von dieser Oberfläche 10 abgekehrten Seite 13 dieses Körpers 1 ausgebildeten Öffnung 55 verbindet, an welche der dünnflüssige Klebstoff 3 heranzubringen ist.

Bei elastisch verformbaren zu verbindenden Oberflächen 10, 20 können relative Formunterschiede durch Gegeneinanderdrücken dieser Oberflächen 10, 20 mit einem Druck P ausgeglichen und auf diese Weise ein noch nicht vorhandener Zwischenraum 30 der geringen mittleren Dicke d zwischen einander gegenübergesetzten Oberflächenbereichen 10₁, 20₁ hergestellt werden, die für die Herstellung der Klebstoffverbindung vorgesehenen sind. Dieses Gegeneinanderdrücken erfolgt zumindest während des sich Ausbreiten- und Aushärtenlassens des Klebstoffs 3 im hergestellten Zwischenraum 30 zwischen diesen Oberflächenbereichen 10₁, 20₁. Zum Gegeneinanderdrücken der zu verbindenden Oberflächen 10, 20 genügt mit ein Druck P von weniger als 1000 cN/mm² meist sogar von weniger als 50 cN/mm².

Bei den in den Figuren dargestellten Beispielen ist z.B. der Körper 1 ein mikroelektrischer und/oder mikromechanischer und/oder mikrooptischen Baustein, dessen auf seinem Oberflächenabschnitt 100 angeordnete Schichten 11 Kontaktschichten aus elektrisch leitendem Material sind, so daß die für die Herstellung der erfindungsgemäßen Klebstoffverbindung vorgesehenen Oberflächenbereiche 10₁ elektrische Kontaktflächen sind.

Der Körper 2 ist ein Substratkörper zum Kontaktieren und Haltern des Bausteins 1, dessen auf seinem Oberflächenabschnitt 200 angeordneten Schichten 21 ebenfalls Kontaktschichten aus elektrisch leitendem Material sind, so daß auch bei diesem Körper 2 die für die Herstellung der erfindungsgemäßen Klebstoffverbindung vorgesehenen Oberflächenbereiche 20₁ elektrische Kontaktflächen sind.

Beim Beispiel nach Figur 1 sind die beiden vorhandenen und jeweils durch eine erfindungsgemäße Klebstoffverbindung mit je einer Kontaktschicht 11 des Körpers 1 verbundenen Kontaktschichten 21 des Körpers 2 z.B. mit elektrischen Kontaktdrähten 22, 23 zum zu und/oder fortleiten elektrischer Energie oder Signale verbunden, beispielsweise durch Lot oder Bonden.

Beim Beispiel nach Figur 8 weist der optoelektronische Baustein 1 beispielsweise eine Laserdiode 15 oder andere Halbleiterlichtquelle auf, deren abgestrahltes Licht 16 in eine auf dem Substratkörper 2 befestigte optische Faser 17 eingekoppelt wird. Zum Fixieren des Bausteins 2 mittels der erfindungsgemäßen Klebstoffverbindung auf dem Substratkörper 2 und Fixieren der Faser 17 auf diesem Körper 2 wird ein und derselbe optisch transparente dünnflüssige Klebstoff 3 verwendet, der im ausgehärteten Zustand vorteilhafterweise eine für das Licht 16 transparente ausgehärtete Klebstoffschicht 35 bildet, die in jedem Zwischenraum 30 dünner als 0,3 µm ist.

Der bei der Herstellung der elektrischen Kontakte verwendete dünnflüssige Klebstoff 3 ist vorzugsweise ein elektrisch isolierender Klebstoff.

Als Vorteilhaft hat sich insbesondere ein dünnflüssiger Klebstoff 3 auf Epoxidbasis erwiesen, der bei elektrischen Kontaktschichten 11, 21 aus Gold eine besonders gute Haftfähigkeit vermittelt, dabei trotz seiner elektrisch isolierenden Wirkung besonders niedrige elektrische Übergangswiderstände von weniger als 1 mΩ·mm² ermöglicht und überdies optisch transparent ist. Auch gute thermische Kontakte lassen sich damit herstellen.

Die mittlere Schichtdicke d1 jeder Schicht 11 des Körpers 1 und die mittlere Schichtdicke d2 jeder Schicht 21 des Körpers 2 sollte höchstens 1 µm betragen, wobei sich auch hier die mittlere Schichtdicke d1 bzw. d2 auf mittlere Profile bezieht.

Zwischen jeweils zwei benachbarten, jeweils für die Herstellung der erfindungsgemäßen Klebstoffverbindung vorgesehenen Oberflächenbereichen 10₁ und 10₁,bzw. 20₁ und 20₁ jedes Körpers 1 bzw. 2 sollte eine mindestens 0,5 µm breite Lücke s bestehen.

Auf einer zu verbindenden Oberfläche 10 bzw.20 sollten zwei oder mehrere getrennte, jeweils für die Herstellung der erfindungsgemäßen Klebstoffverbindung vorgesehene Oberflächenbereiche 10₁ bzw. 20₁ in einem Rastermaß a (siehe Figur 5) von mindestens 2 µm angeordnet sein. Dabei bedeutet der Begriff Rastermaß nicht nur das in der Figur 5 in der Richtung der Breite b (siehe Figuren 1 und 6) gezeigte Rastermaß a, sondern, insbesondere im Falle einer matrixförmigen Anordnung der Oberflächenbereiche 10₁ und/oder 20₁ auf der Oberfläche 10 bzw. 20, auch ein Rastermaß in der Richtung c der Figur 1, das gleich dem Rastermaß a in der Richtung b oder verschieden davon sein kann.

Mit dem erfindungsgemäßen Verfahren können beispielsweise hybride optische oder elektrische Module hergestellt werden.

## Patentansprüche

1. Klebeverbund zwischen Oberflächen einer Rauhtiefe von weniger als 0,3 µm, der zumindest einen mit Klebstoff gefüllten Zwischenraum mit einer mittleren Dicke von weniger als 0,3 µm umfaßt, wobei der ungehärtete Klebstoff eine derart niedrige dynamische Viskosität aufweist, daß infolge von Kapillarwirkung der Zwischenraum mit Klebstoff gefüllt ist.

2. Klebeverbund nach Anspruch 1, wobei der ungehärtete Klebstoff eine dynamischen Viskosität von nicht mehr als 10³ mPa*s hat.

3. Klebeverbund nach einem der Ansprüche 1 oder 2, bei dem zumindest ein mit Klebstoff gefüllter Zwischenraum eine flächige Ausdehnung von 20x20µm² hat.

4. Klebeverbund nach einem der vorstehenden Ansprüche, der einen elektrischen Übergangswiderstand von unter 1mΩ/mm² hat.

5. Klebeverbund nach einem der vorstehenden Ansprüche, durch den ein mikroelektrischer, mikromechanischer und/oder mikrooptischer Baustein mit einem Substratkörper verbunden ist.

6. Klebstoffverbund nach einem der vorstehenden Ansprüche,
**dadurch gekennzeichnet,**
**daß** die durch die Schicht (35) aus dem ausgehärteten Klebstoff (3) miteinander verbundenen Oberflächenbereiche (10₁, 20₁)
- ein oder mehrere Oberflächenbereiche (10₁) in Form von Kontaktflächen eines Oberflächenabschnitts (10) eines mikroelektrischen und/oder -mechanischen und/oder -optischen Bausteins (1) und
- ein oder mehrere, jeweils einem oder mehreren Oberflächenbereichen (10₁) des Oberflächenabschnitts (10) des Bausteins (1) zugeordnete Oberflächenbereiche (20₁) in Form von Kontaktflächen eines Oberflächenabschnitts (20) eines Substratkörpers (2) sind, wobei
- die Oberflächenbereiche (10₁, 20₁) des Bausteins (1) und Substratkörpers (2) jeweils eine Fläche von mindestens 20×20 µm Größe einnehmen und je eine Rauhtiefe (t) von weniger als 0,3 µm aufweisen.

7. Verfahren zur Herstellung einer mechanisch festen Klebstoffverbindung zwischen Oberflächen (10, 20),
bei dem
- zu verbindende Oberflächen (10, 20), verwendet werden, deren jede
- zumindest je einen Oberflächenbereich (10₁, 20₁) aufweist, der sich
- über eine Fläche erstreckt,
- eine Rauheit mit einer geringen Rauhtiefe (t) aufweist
und
- zur Herstellung der Klebstoffverbindung vorgesehen ist, mit den Schritten:
Erzeugen,
- durch einander Gegenübersetzen der Oberflächenbereiche (10₁, 20₁) der geringen Rauhtiefe (t) der zu verbindenden Oberflächen (10, 20),
eines
- flächig ausgedehnten,
- sich über eine Fläche erstreckenden,
- eine geringe mittlere Dicke (d) aufweisenden und
- einen aushärtbaren Klebstoff (3)
- einer Viskosität von maximal 103 mPa*s enthaltenden,
- Zwischenraums (30) zwischen diesen Oberflächenbereichen (10₁, 20₁)
und
- Aushärtenlassen des im Zwischenraum (30) enthaltenden
- Klebstoffs (3)
- im wesentlichen unter Beibehaltung der geringen mittleren Dicke (d) des Zwischenraums (30),
**gekennzeichnet dadurch**,
Verwendung
- von Oberflächenbereichen (10₁, 20₁), die,
- zur Herstellung der Klebstoffverbindung vorgesehen,
- je eine Rauhtiefe (t) von weniger als 0,3 µm aufweisen und
- eines Zwischenraums (30), der,
- mit dem Klebstoff (3) infolge der Kapillarwirkung des ungehärteten Klebstoffs gefüllt ist,
- eine geringe mittlere Dicke (d) von weniger als 0,3 µm aufweist und sich
- über eine Fläche von wenigstens 20x20 µm² erstreckt.

8. Verfahren nach Anspruch 7,
**gekennzeichnet durch**,
- flächiges sich Ausbreitenlassen eines
- dünnflüssigen Klebstoffs (3)
- einer derart niedrigen dynamischen Viskosität,
- daß sich der Klebstoff (3)
infolge von Kapillarwirkung
- flächig im Zwischenraum (30) der geringen mittleren Dicke (d) von weniger als 0,3 µm ausbreitet.

9. Verfahren nach Anspruch 7 oder 8,
**dadurch gekennzeichnet,**
**daß** ein Klebstoff (3) verwendet wird, der eine dynamische Viskosität von höchstens 10³ mPa·s bei einer vorbestimmten Temperatur (T) aufweist, bei der sich der Klebstoff (3) flächig im Zwischenraum (30) ausbreitet.

10. Verfahren nach einem der Ansprüche 7 bis 9,
**dadurch gekennzeichnet,**
**daß** die für die Herstellung der Klebstoffverbindung vorgesehenen und einander gegenübergesetzten Oberflächenbereiche (10₁, 20₁) in unmittelbaren Kontakt miteinander gebracht werden, wobei zwischen den in Kontakt miteinander stehenden Oberflächenbereichen (10₁, 20₁) aufgrund der bestehenden Rauhheit der eine Kapillarwirkung entfaltende, flächig ausgedehnte Zwischenraum (30) der geringen mittleren Dicke (d) verbleibt.

11. Verfahren nach einem der Ansprüche 7 bis 10,
**dadurch gekennzeichnet, daß** der Klebstoff (3) an eine mit dem Zwischenraum (30) verbundene Öffnung (55) herangebracht wird, von welcher der Klebstoff (3) aufgrund von Kapillarwirkung in den Zwischenraum (30) eindringt und sich flächig im Zwischenraum (30) ausbreitet.

12. Verfahren nach einem der Ansprüche 7 bis 11,
**dadurch gekennzeichnet, daß**
- auf zumindest eine (10; 20) der zu verbindenden Oberflächen (10, 20) Klebstoff (3) in so geringer Menge auf zumindest eine der zu verbindenden Oberflächen (10, 20) aufgebracht, daß er diese Oberfläche (10, 20) und/oder einen zur Herstellung der Klebstoffverbindung vorgesehenen Oberflächenbereich (10₁, 20₁) dieser Oberfläche (10, 20) nur teilweise bedeckt. daß danach
- die zu verbindenden Oberflächen (10, 20) bei einander gegenübergesetzten Oberflächenbereichen (10₁, 20₁) gegeneinandergedrückt werden, so daß sich ein durch den zwischen diesen Oberflächen (10, 20) befindlichen Klebstoff (3) bedingter, im Vergleich zur geringen mittleren Dicke (d) größerer Abstand (D) zwischen diesen Oberflächenbereichen (10₁, 20₁) während des sich flächig zwischen diesen Oberflächenbereichen (10₁, 20₁) verteilenden Klebstoffs (3) soweit verringert, daß zwischen den Oberflächenbereichen (10₁, 20₁) der mit Klebstoff (3) gefüllte, flächig ausgedehnte Zwischenraum (30) der geringen mittleren Dicke (d) entsteht, wonach
- der Klebstoff (3) ausgehärtet wird.

13. Verfahren nach einem der Ansprüche 7 bis 12,
**dadurch gekennzeichnet,**
**daß** die zu verbindenden Oberflächen (10, 20) elastisch verformbar sind und zum Ausgleich von Formunterschieden zwischen den Oberflächen (10, 20) zwecks Herstellens und Aufrechterhaltens des Zwischenraums (30) der geringen mittleren Dicke (d) zwischen den einander gegenübergesetzten, für die Herstellung der Klebstoffverbindung vorgesehenen Oberflächenbereichen (10₁, 20₁) zumindest während des sich Ausbreiten- und Aushärtenlassens des Klebstoffs (3) im Zwischenraum (30) zwischen diesen Oberflächenbereichen (10₁, 20₁) gegeneinandergedrückt werden.

14. Verfahren nach Anspruch 13,
**dadurch gekennzeichnet,**
**daß** die zu verbindenden Oberflächen (10, 20) mit einem Druck (P) von weniger als 1000 cN/mm² gegeneinandergedrückt werden.

15. Verfahren nach Anspruch 14,
**dadurch gekennzeichnet,**
**daß** die zu verbindenden Oberflächen (10, 20) mit einem Druck (P) von weniger als 50 cN/mm² gegeneinandergedrückt werden.

16. Verfahren nach einem der Ansprüche 7 bis 15,
**gekennzeichnet durch**
ein sich Ausbreitenlassen des Klebstoffs (3) im Zwischenraum (30) der geringen mittleren Dicke (d) bei einer Temperatur (T) größer als 20°C.

17. Verfahren nach einem der Ansprüche 7 bis 16,
**dadurch gekennzeichnet,**
**daß** der dünnflüssige Klebstoff (3) durch zumindest einen mit einem Zwischenraum (30) der geringen mittleren Dicke (d) in Klebstoffverbindung stehenden Kanal (5), in welchem sich der Klebstoff (3) schneller im Vergleich zu einer gegebenen Ausbreitungsgeschwindigkeit des Klebstoffs (3) im Zwischenraum (30) aufgrund von Kapillarwirkung ausbreitet, zum Zwischenraum (30) gebracht wird.

18. Verfahren nach Anspruch 17,
**dadurch gekennzeichnet,**
**daß** ein Kanal (5) verwendet wird, der mit einer Öffnung (50) in eine zu verbindende Oberfläche (10, 20) mündet.

19. Verfahren nach Anspruch 17 oder 18,
**dadurch gekennzeichnet, daß**
- ein sich in einer Längsrichtung (53) parallel zu einer zu verbindenden Oberfläche (10, 20) erstreckender Kanal (5) mit zumindest einer Längsseite (51, 52) verwendet wird, die mit dem Zwischenraum (30) verbunden ist und von der sich der Klebstoff (3) in Richtung (31, 32) quer zur Längsrichtung (53) des Kanals (5) infolge von Kapillarwirkung in den Zwischenraum (30) ausbreitet.

20. Verfahren nach einem der Ansprüche 7 bis 19,
**dadurch gekennzeichnet,**
**daß** ein optisch transparenter Klebstoff (3) verwendet wird.

21. Verfahren nach einem der Ansprüche 7 bis 20,
**dadurch gekennzeichnet,**
**daß** ein elektrisch isolierender Klebstoff (3) verwendet wird.

22. Verfahren nach Anspruch 7 bis 21,
**dadurch gekennzeichnet,**
**daß** ein Klebstoff (3) auf Epoxidbasis verwendet wird.

23. Verfahren nach Anspruch 10 und 21 oder 22,
**dadurch gekennzeichnet,**
**daß** einander gegenüberzusetzende, für die Herstellung der Klebstoffverbindung vorgesehene Oberflächenbereiche (10₁, 20₁) in Form elektrischer Kontaktflächen verwendet werden.

24. Verfahren nach Anspruch 10 und einem der Ansprüche 21 bis 23,
**dadurch gekennzeichnet,**
**daß** einander gegenüberzusetzende, für die Herstellung der Klebstoffverbindung vorgesehene Oberflächenbereiche (10₁, 20₁) in Form thermischer Kontaktflächen verwendet werden.

25. Verfahren nach Anspruch 23 oder 24,
**dadurch gekennzeichnet,**
**daß** eine aus Gold bestehende Kontaktfläche (10₁, 20₁) verwendet wird.

26. Verfahren nach einem der Anspruche 23 bis 25,
**dadurch gekennzeichnet,**
**daß** zu verbindende Oberflächen (10, 20) verwendet werden, die
- mehr als zwei einander zugeordnete,
- für die Herstellung der Klebstoffverbindung vorgesehene,
- jeweils eine Fläche von mindestens 20×20 µm² Große einnehmende und
- je eine geringe Rauhtiefe (t) von weniger als 0,3 µm aufweisende
- Oberflächenbereiche (10₁, 20₁) aufweisen, wobei
- diese Oberflächenbereiche (10₁, 20₁) derart einander gegenübergesetzt werden, daß sich
- einander zugeordnete Oberflächenbereiche (10₁, 20₁) gegenüberstehen und
- zwischen jedem Paar einander gegenüberstehender Oberflächenbereiche (10₁, 20₁)
- je ein flächig ausgedehnter Zwischenraum (30) erzeugt ist,
- der sich über eine Fläche von wenigstens 20×20 µm² Größe erstreckt und
- eine geringe mittlere Dicke (d) von weniger als 0,3 µm aufweist.

27. Verfahren nach einem der Ansprüche 7 bis 26,
**dadurch gekennzeichnet,**
**daß** eine zu verbindende Oberfläche (10, 20) durch einen
- eine Seite eines Körpers (1, 2) bildenden Oberflächenabschnitt (100, 200) definiert ist, auf dem
- in einem oder mehreren voneinander getrennten Bereichen
- je einer Fläche von wenigstens 20×20 µm² Größe
- je eine Schicht (11, 21) aus einem vorbestimmten Material aufgebracht ist, deren
- vom Körper (1, 2) abgekehrte Oberfläche
- eine Rauheit mit einer geringen Rauhtiefe (t) von
- weniger als 0,3 µm aufweist und
- je einen für die Herstellung der Klebstoffverbindung vorgesehenen Oberflächenbereich (10₁, 20₁) bildet.

28. Verfahren nach Anspruch 27,
**dadurch gekennzeichnet,**
**daß** eine Schicht (11, 21) einer mittleren Schichtdicke (d1, d2) von höchstens 1 µm verwendet wird.

29. Verfahren nach einem der Ansprüche 26 bis 28,
**dadurch gekennzeichnet,**
**daß** eine zu verbindende Oberfläche (10, 20) verwendet wird, bei der zwischen zwei getrennten benachbarten, jeweils für die Herstellung der Klebstoffverbindung vorgesehenen Oberflächenbereichen (10₁, 20₁) eine mindestens 0,5 µm breite Lücke (s) besteht.

30. Verfahren nach einem der Ansprüche 26 bis 29,
**dadurch gekennzeichnet,**
**daß** eine zu verbindende Oberfläche (10, 20) verwendet wird, bei der zwei oder mehrere getrennte, jeweils für die Herstellung der Klebstoffverbindung vorgesehene Oberflächenbereiche (10₁, 20₁) in einem Rastermaß (a) von wenigstens 2 µm angeordnet sind.

31. Verfahren nach einem der Ansprüche 26 bis 30,
**dadurch gekennzeichnet,**
**daß** als zu verbindende Oberflächen
- ein für die Herstellung der Klebstoffverbindung vorgesehene Oberflächenbereiche (10₁) in Form von Kontaktflächen aufweisender Oberflächenabschnitt (10) eines mikroelektrischen und/oder -mechanischen und/oder -optischen Bausteins (1) und
- ein Kontaktflächen (10₁) des Oberflächenabschnitts (10) des Bausteins (1) zugeordnete, für die Herstellung der Klebstoffverbindung vorgesehene Oberflächenbereiche (20₁) in Form von Kontaktflächen aufweisender Oberflächenabschnitt (20) eines Substratkörpers (2) verwendet werden.

## Claims

1. Adhesively bonded assembly between surfaces of a surface roughness of less than 0.3 µm, which comprises at least one intermediate space with an average thickness of less than 0.3 µm filled with an adhesive, the uncured adhesive having such a low dynamic viscosity that the intermediate space is filled with adhesive as a result of capillary action.

2. Adhesively bonded assembly according to Claim 1, the uncured adhesive having a dynamic viscosity of no more than 10³ mPa*s.

3. Adhesively bonded assembly according to either of Claims 1 and 2, in which at least one intermediate space filled with adhesive has a planar extent of 20 × 20 µm².

4. Adhesively bonded assembly according to one of the preceding claims, which has an electrical transition resistance of below 1 mΩ/mm².

5. Adhesively bonded assembly according to one of the preceding claims, by which a microelectrical, micromechanical and/or microoptical module is bonded to a substrate body.

6. Adhesively bonded assembly according to one of the preceding claims, **characterized in that** the surface regions (10₁, 20₁) bonded to one another by the layer (35) of the cured adhesive (3) have
- one or more surface regions (10₁) in the form of contact areas of a surface segment (10) of a microelectrical and/or micromechanical and/or microoptical module (1) and
- one or more surface regions (20₁), respectively assigned to one or more surface regions (10₁) of the surface segment (10) of the module (1), in the form of contact areas of a surface segment (20) of a substrate body (2),
- the surface regions (10₁, 20₁) of the module (1) and substrate body (2) respectively assuming a surface area of at least 20 × 20 µm in size and each having a surface roughness (t) of less than 0.3 µm.

7. Method for producing a mechanically strong adhesive bond between surfaces (10, 20), in which
- surfaces (10, 20) to be bonded are used, each of which
- has at least in each case a surface region (10₁, 20₁) which
- extends over a surface area,
- has a roughness with a small surface roughness (t)
and
- is intended for producing the adhesive bond, with the steps of:
producing
- by placing opposite one another the surface regions (10₁, 20₁) of small surface roughness (t) of the surfaces (10, 20) to be bonded,
an intermediate space (30)
- of a planar extent,
- extending over a surface area,
- having a small average thickness (d) and
- containing a curable adhesive (3)
- of a viscosity of at most 10³ mPa*s,
between these surface regions (10₁, 20₁)
and
- allowing the adhesive (3) contained in the intermediate space (30) to cure
- while substantially retaining the small average thickness (d) of the intermediate space (30),
**characterized by**
use
- of surface regions (10₁, 20₁) which
- are intended for producing the adhesive bond,
- each have a surface roughness (t) of less than 0.3 µm
and
- an intermediate space (30) which
- is filled with the adhesive (3) as a result of the capillary action of the uncured adhesive,
- has a small average thickness (d) of less than 0.3 µm and
- extends over a surface area of at least 20 × 20 µm².

8. Method according to Claim 7,
**characterized by**
- spreading in a planar fashion of a
- low-viscosity adhesive (3)
- of such a low dynamic viscosity
- that the adhesive (3)
as a result of capillary action
- spreads in a planar fashion in the intermediate space (30) of small average thickness (d) of less than 0.3 µm.

9. Method according to Claim 7 or 8, **characterized in that** an adhesive (3) which has a dynamic viscosity of at most 10³ mPa.s at a predetermined temperature (T) at which the adhesive (3) spreads in a planar fashion in the intermediate space (30) is used.

10. Method according to one of Claims 7 to 9, **characterized in that** the surface regions (10₁, 20₁) intended for producing the adhesive bond and placed opposite one another are brought into direct contact with one another, with the planar-extended intermediate space (30) that is of small average thickness (d) and develops a capillary action remaining between the surface regions (10₁, 20₁) in contact with one another on account of the existing roughness.

11. Method according to one of Claim 7 to 10, **characterized in that** the adhesive (3) is supplied to an opening (55) which is connected to the intermediate space (30) and, from this opening, the adhesive (3) penetrates into the intermediate space (30) on account of capillary action and spreads in a planar fashion in the intermediate space (30).

12. Method according to one of Claims 7 to 11, **characterized in that**
- adhesive (3) is deposited on at least one (10; 20) of the surfaces (10, 20) to be bonded in such a small amount that it only partially covers this surface (10, 20) and/or a surface region (10₁, 20₁) of this surface (10, 20) intended for producing the adhesive bond, **in that** after that
- the surfaces (10, 20) to be bonded are pressed against one another with surface regions (10₁, 20₁) placed opposite one another, so that a distance (D) that is greater in comparison with the small average thickness (d) between these surface regions (10₁, 10₂), caused by the adhesive (3) located between these surfaces (10, 20), is reduced while the adhesive (3) distributes itself. in a planar fashion between these surface regions (10₁, 20₁) to the extent that the planar-extended intermediate space (30) of small average thickness (d) filled with adhesive (3) is produced between the surface regions (10₁, 20₁), after which
- the adhesive (3) is cured.

13. Method according to one of Claims 7 to 12, **characterized in that** the surfaces (10, 20) to be bonded are elastically deformable and to compensate for differences in shape between the surfaces (10, 20) are pressed against one another for the purpose of producing and maintaining the intermediate space (30) of small average thickness (d) between the surface regions (10₁, 20₁) placed opposite one another and intended for producing the adhesive bond, at least during the spreading and curing of the adhesive (3) in the intermediate space (30) between these surface regions (10₁, 20₁).

14. Method according to Claim 13, **characterized in that** the surfaces (10, 20) to be bonded are pressed against one another with a pressure (P) of less than 1000 cN/mm².

15. Method according to claim 14, **characterized in that** the surfaces (10, 20) to be bonded are pressed against one another with a pressure (P) of less than 50 cN/mm².

16. Method according to one of Claims 7 to 15, **characterized by** allowing the adhesive (3) to spread in the intermediate space (30) of small average thickness (d) at a temperature (T) greater than 20°C.

17. Method according to one of Claims 7 to 16, **characterized in that** the low-viscosity adhesive (3) is supplied to the intermediate space (30) through at least one duct (5) which is in adhesive connection with an intermediate space (30) of small average thickness (d) and in which the adhesive (3) spreads more rapidly in comparison with a given spreading rate of the adhesive (3) in the intermediate space (30) on account of capillary action.

18. Method according to Claim 17, **characterized in that** a duct (5) which opens out with an opening (50) into a surface (10, 20) to be bonded is used.

19. Method according to Claim 17 or 18, **characterized in that**
- a duct (5) which extends in a longitudinal direction (53) parallel to a surface (10, 20) to be bonded and has at least one longitudinal side (51, 52) which is connected to the intermediate space (30) and from which the adhesive (3) spreads into the intermediate space (30) in a direction (31, 32) transverse to the longitudinal direction (53) of the duct (5) as a result of capillary action is used.

20. Method according to one of Claims 7 to 19, **characterized in that** an optically transparent adhesive (3) is used.

21. Method according to one of Claims 7 to 20, **characterized in that** an electrically insulating adhesive (3) is used.

22. Method according to Claims 7 to 21, **characterized in that** an epoxy-based adhesive (3) is used.

23. Method according to Claims 10 and 21 or 22, **characterized in that** surface regions (10₁, 20₁) to be placed opposite one another and intended for producing the adhesive bond in the form of electrical contact areas are used.

24. Method according to Claim 10 and one of Claims 21 to 23, **characterized in that** surface regions (10₁, 20₁) to be placed opposite one another and intended for producing the adhesive bond in the form of thermal contact areas are used.

25. Method according to Claim 23 or 24, **characterized in that** a contact area (10₁, 20₁) consisting of gold is used.

26. Method according to one of Claims 23 to 25,
**characterized in that** surfaces (10, 20) to be connected which have
- more than two surface regions (10₁, 20₁) which are assigned to one another,
- intended for producing the adhesive bond,
- respectively assume a surface area of at least 20 × 20 µm² in size and
- each have a small surface roughness (t) of less than 0.3 µm
are used,
- these surface regions (10₁, 20₁) being placed opposite one another in such a way that
- surface regions (10₁, 20₁) assigned to one another are opposite one another and
- between each pair of mutually opposite surface regions (10₁, 20₁)
- there is produced in each case a planar-extended intermediate space (30),
- which extends over a surface area of at least 20 × 20 µm² in size and
- has a small average thickness (d) of less than 0.3 µm.

27. Method according to one of Claims 7 to 26, **characterized in that** a surface (10, 20) to be bonded is defined by
- a surface segment (100, 200) which forms one side of a body (1, 2) and on which
- there is deposited in one or more regions that are separate from one another
- in each case of a surface area of at least 20 x 20 µm² in size
- in each case a layer (11, 21) of a predetermined material,
- the surface of which facing away from the body (1, 2)
- has a roughness with a small surface roughness (t) of less than 0.3 µm and
- in each case forms a surface region (10₁, 20₁) intended for producing the adhesive bond.

28. Method according to Claim 27, **characterized in that** a layer (11, 21) of an average layer thickness (d1, d2) of at most 1 µm is used.

29. Method according to one of Claims 26 to 28, **characterized in that** a surface (10, 20) to be bonded on which a gap (s) at least 0.5 µm wide exists between two separate adjacent surface regions (10₁, 20₁) respectively intended for producing the adhesive bond is used.

30. Method according to one of Claims 26 to 29, **characterized in that** a surface (10, 20) to be bonded on which two or more separate surface regions (10₁, 20₁), respectively intended for producing the adhesive bond, are arranged at gridlike intervals (a) of at least 2 µm is used.

31. Method according to one of Claims 26 to 30, **characterized in that**
- a surface segment (10) of a microelectrical and/or micromechanical and/or microoptical module (1) having surface regions (10₁) which are intended for producing the adhesive bond and are in the form of contact areas and
- a surface segment (20) of a substrate body (2) having surface regions (20₁) which are assigned to contact areas (10₁) of the surface segment (10) of the module (1) and are in the form of contact areas
are used as surfaces to be bonded.

## Revendications

1. Liaison collée entre des surfaces dont la rugosité a une profondeur inférieure à 0,3 µm, qui comprend au moins un espace intermédiaire rempli d'adhésif et d'une épaisseur moyenne inférieure à 0,3 µm, l'adhésif non durci présentant une viscosité dynamique suffisamment faible pour que l'espace intermédiaire se remplisse d'adhésif sous l'action de la capillarité.

2. Liaison collée selon la revendication 1, dans laquelle l'adhésif non durci a une viscosité dynamique non supérieure à 10³ mPa.s.

3. Liaison collée selon l'une quelconque des revendications 1 ou 2, dans laquelle au moins un espace intermédiaire rempli d'adhésif présente une superficie qui s'étend sur 20 × 20 µm².

4. Liaison collée selon l'une quelconque des revendications précédentes, dont la résistance électrique de transfert est inférieure à 1 mΩ/mm².

5. Liaison collée selon l'une quelconque des revendications précédentes, par laquelle un composant microélectrique, micromécanique et/ou microoptique est relié à un corps de substrat.

6. Liaison collée selon l'une quelconque des revendications précédentes, **caractérisée en ce que**:
les zones de surface (10₁, 20₁) reliées l'une à l'autre par la couche (35) d'adhésif durci (3)
- sont une ou plusieurs zones de surface (10₁) qui présentent la forme de surfaces de contact d'une partie de surface (10) d'un composant microélectrique et/ou micromécanique et/ou microoptique (1) et
- sont une ou plusieurs zones de surface (20₁) qui présentent la forme de surfaces de contact d'une partie de surface (20) d'un corps de substrat (2), qui sont chacune associées à une ou plusieurs zones de surface (10₁) de la partie de surface (10) du composant (1),
- les zones de surface (10₁, 20₁₎) du composant (1) et du corps de substrat (2) occupant chacune une superficie d'une taille d'au moins 20 × 20 µm et présentant chacune une rugosité d'une profondeur (t) inférieure à 0,3 µm.

7. Procédé pour établir une liaison collée mécaniquement résistante entre des surfaces (10, 20), dans lequel
- on utilise des surfaces (10, 20) à relier dont chacune
- présente au moins une zone de surface (10₁, 20₁) qui
- s'étend sur une superficie,
- présente une rugosité de faible profondeur (t)
et
- est prévue pour établir la liaison collée,
avec les étapes qui consistent à:
- en plaçant l'une en face de l'autre les zones de surface (10₁, 20₁) à rugosité de faible profondeur (t) des surfaces (10, 20) à relier, créer entre ces zones de surface (10₁, 20₁) un espace intermédiaire (30)
- qui s'étend en surface
- qui s'étend sur une superficie
- qui présente une faible épaisseur moyenne (d) et
- qui contient un adhésif durcissable (3)
- dont la viscosité est d'au plus 103 mPa.s,
et
- faire durcir l'adhésif (3) contenu dans l'espace intermédiaire (30)
- essentiellement en maintenant la faible épaisseur moyenne (d) de l'espace intermédiaire (30),
**caractérisé en ce que** l'on utilise des zones de surface (10₁, 20₁) qui
- sont prévues pour établir la liaison collée
- présentent chacune une rugosité d'une profondeur (t) inférieure à 0,3 µm et
- un espace intermédiaire (30)
- qui est rempli d'adhésif (3) sous l'action de la capillarité de l'adhésif non durci,
- qui présente une faible épaisseur moyenne (d), inférieure à 0,3 µm et
- qui s'étend sur une superficie d'au moins 20 × 20 µm².

8. Procédé selon la revendication 7, **caractérisé par** l'étalement en surface
- d'un adhésif (3) à haute fluidité
- d'une viscosité dynamique suffisamment faible pour que l'adhésif (3)
- s'étale en surface sous l'action de la capillarité dans l'espace intermédiaire (30) de faible épaisseur moyenne (d), inférieure à 0,3 µm.

9. Procédé selon la revendication 7 ou 8, **caractérisé en ce que** l'on utilise un adhésif (3) qui présente une viscosité dynamique d'au plus 10³ mPa.s à une température (T) prédéterminée à laquelle l'adhésif (3) s'étale en surface dans l'espace intermédiaire (30).

10. Procédé selon l'une quelconque des revendications 7 à 9, **caractérisé en ce que** les zones de surface (10₁, 20₁) placées l'une en face de l'autre et prévues pour l'établissement de la liaison collée sont amenées en contact mutuel direct, tandis que l'espace intermédiaire (30) qui déploie l'action de la capillarité à cause de la rugosité existante, étendu en surface et de faible épaisseur moyenne (d) est maintenu entre les zones de surface (10₁, 20₁) placées en contact mutuel.

11. Procédé selon l'une quelconque des revendications 7 à 10, **caractérisé en ce que** l'adhésif (3) est amené à une ouverture (55) reliée à l'espace intermédiaire (30), ouverture depuis laquelle l'adhésif (3) pénètre dans l'espace intermédiaire (30) sous l'action de la capillarité et s'étale en surface dans l'espace intermédiaire (30).

12. Procédé selon l'une quelconque des revendications 7 à 11, **caractérisé en ce que**
- sur au moins l'une (10; 20) des surfaces (10, 20) à relier, un adhésif (3) est appliqué sur au moins l'une des surfaces (10, 20) à relier en quantité suffisamment faible pour qu'il ne recouvre que partiellement cette surface (10, 20) et/ou une zone (10₁, 20₁) de cette surface (10, 20) prévue pour l'établissement de la liaison collée,
**en ce qu'**ensuite, les surfaces (10, 20) à relier sont poussées l'une contre l'autre, les zones de surface (10₁, 20₁) étant placées l'une en face de l'autre de telle sorte qu'un écart (D) entre ces zones de surface (10₁, 20₁), supérieur à la petite épaisseur moyenne (d) et provoqué par l'adhésif (3) situé entre ces surfaces (10, 20), se réduit pendant que l'adhésif (3) se répartit en surface entre ces zones de surface (10₁, 20₁) jusqu'à ce qu'entre les zones de surface (10₁, 20₁), on obtienne l'espace intermédiaire (30) de faible épaisseur moyenne (d), rempli d'adhésif (3) et étendu en surface, suite à quoi
- l'adhésif (3) est durci.

13. Procédé selon l'une quelconque des revendications 7 à 12, **caractérisé en ce que** les surfaces (10, 20) à relier sont élastiquement déformables et **en ce que**, pour compenser les différences de forme entre les surfaces (10, 20) en vue d'établir et de maintenir l'espace intermédiaire (30) de faible épaisseur moyenne (d) entre les zones de surface (10₁, 20₁) situées l'une en face de l'autre et prévues pour l'établissement de la liaison collée, elles sont poussées l'une contre l'autre au moins pendant l'étalement et le durcissement de l'adhésif (3) dans l'espace intermédiaire (30) situé entre ces zones de surface (10₁, 20₁).

14. Procédé selon la revendication 13, **caractérisé en ce que** les surfaces (10, 20) à relier sont poussées l'une contre l'autre sous une pression (P) inférieure à 1000 cN/mm².

15. Procédé selon la revendication 14, **caractérisé en ce que** les surfaces (10, 20) à relier sont poussées l'une contre l'autre sous une pression (P) inférieure à 50 cN/mm².

16. Procédé selon l'une quelconque des revendications 7 à 15, **caractérisé par** l'étalement de l'adhésif (3) dans l'espace intérieur (30) de faible épaisseur moyenne (d) à une température (T) supérieure à 20° C.

17. Procédé selon l'une quelconque des revendications 7 à 16, **caractérisé en ce que** l'adhésif (3) à haute fluidité est amené dans l'espace intermédiaire (30) par au moins un canal (5) en communication d'écoulement d'adhésif avec un espace intermédiaire (30) de faible épaisseur moyenne (d) et dans lequel l'adhésif (3) s'étale à une vitesse plus grande qu'une vitesse donnée d'étalement de l'adhésif (3) dans l'espace intermédiaire (30) sous l'action de la capillarité.

18. Procédé selon la revendication 17, **caractérisé en ce que** l'on utilise un canal (5) qui débouche par une ouverture (50) dans une surface (10, 20) à relier.

19. Procédé selon la revendication 17 ou 18, **caractérisé en ce que** l'on utilise un canal (5) dont la direction longitudinale (53) s'étend parallèlement à l'une des surfaces (10, 20) à relier, dont au moins un côté longitudinal (51, 52) est relié à l'espace intermédiaire (30) et depuis lequel l'adhésif (3) s'étale dans l'espace intermédiaire (30) sous l'action de la capillarité dans une direction (31, 32) transversale par rapport à la direction longitudinale (53) du canal (5).

20. Procédé selon l'une quelconque des revendications 7 à 19, **caractérisé en ce que** l'on utilise un adhésif (3) optiquement transparent.

21. Procédé selon l'une quelconque des revendications 7 à 20, **caractérisé en ce que** l'on utilise un adhésif (3) électriquement isolant.

22. Procédé selon les revendications 7 à 21, **caractérisé en ce que** l'on utilise un adhésif (3) à base d'époxy.

23. Procédé selon les revendications 10 et 21 ou 22, **caractérisé en ce que** l'on utilise des zones de surface (10₁, 20₁) situées l'une en face de l'autre et prévues pour l'établissement de la liaison collée qui présentent la forme de surfaces de contact électrique.

24. Procédé selon la revendication 10 et l'une quelconque des revendications 21 à 23, **caractérisé en ce que** l'on utilise des zones de surface (10₁, 20₁) situées l'une en face de l'autre et prévues pour l'établissement de la liaison collée qui présentent la forme de surfaces de contact thermique.

25. Procédé selon la revendication 23 ou 24, **caractérisé en ce que** l'on utilise une surface de contact (10₁, 20₁) constituée d'or.

26. Procédé selon l'une quelconque des revendications 23 à 25, **caractérisé en ce que** l'on utilise des surfaces (10, 20) à relier
- qui présentent plus de deux zones de surface (10₁, 20₁) mutuellement associées,
- qui sont prévues pour l'établissement de la liaison collée,
- qui occupent chacune une superficie d'une taille d'au moins 20 × 20 µm² et
- qui présentent chacune une rugosité de faible profondeur (t), inférieure à 0,3 µm,
- qui présentent des zones de surface (10₁, 20₁),
- ces zones de surface (10₁, 20₁) étant placées les unes en face des autres de telle sorte que
- des zones de surface (10₁, 20₁) mutuellement associées soient placées l'une en face de l'autre et
- un espace intermédiaire (30) qui s'étend en surface soit créé entre chaque paire de zones de surface (10₁, 20₁) situées l'une en face de l'autre,
- s'étende sur une superficie d'une taille d'au moins 20 × 20 µm² et
- présente une faible épaisseur moyenne (d) inférieure à 0,3 µm.

27. Procédé selon l'une quelconque des revendications 7 à 26, **caractérisé en ce que** l'une des surfaces (10, 20) à relier est définie par
- un côté d'un corps (1, 2) qui forme une partie de surface (100, 200), sur lequel
- dans une ou plusieurs zones séparées l'une de l'autre,
- chacune d'une superficie d'une taille d'au moins 20 × 20 µm²,
- on% applique une couche (11, 21) respective d'un matériau prédéterminé,
- dont la surface non tournée vers le corps (1, 2)
- qui présente une rugosité d'une faible profondeur (t), inférieure à 0,3 µm et
- qui forme chaque fois une zone de surface (10₁, 20₁) prévue pour l'établissement de la liaison collée.

28. Procédé selon la revendication 27, **caractérisé en ce que** l'on utilise une couche (11, 21) dont l'épaisseur moyenne (d1, d2) est d'au plus 1 µm.

29. Procédé selon l'une quelconque des revendications 26 à 28, **caractérisé en ce que** l'on utilise une surface (10, 20) à relier dans laquelle il reste entre deux zones de surface (10₁, 20₁) voisines et séparées un interstice d'une largeur d'au moins 0,5 µm qui est prévu pour l'établissement de la liaison collée.

30. Procédé selon l'une quelconque des revendications 26 à 29, **caractérisé en ce que** l'on utilise une surface à relier (10, 20) dans laquelle deux ou plusieurs zones de surface (10₁, 20₁) séparées, chaque fois prévues pour l'établissement de la liaison collée, sont disposées sous une trame (a) d'au moins 2 µm.

31. Procédé selon l'une quelconque des revendications 26 à 30, **caractérisé en ce que** comme surfaces à relier, on utilise
- une partie de surface (10) d'un composant microélectrique et/ou micromécanique et/ou microoptique (1), présentant des zones de surface (10₁) prévues pour l'établissement de la liaison collée et ayant la forme de surfaces de contact et
- une zone de surface (20) d'un corps de substrat (2) qui présente des zones de surface (20₁) qui ont la forme de surfaces de contact, qui sont prévues pour l'établissement de la liaison collée et qui sont associées à des surfaces de contact (10₁) de la partie de surface (10) du composant (1).
